# EUROPEAN PATENT SPECIFICATION

(11) **EP 0 948 139 B1**
(45) Date of publication and mention of the grant of the patent: **27.11.2002**
(21) Application number: 98830207.1
(22) Date of filing: 03.04.1998
(51) Int. Cl.: H03M 3/00, H03M 3/02

(54) **Stabilization of single loop sigma delta modulators of a high order**
Stabilisation eines einschleifigen Sigma Delta Modulators höherer Ordnung
Stabilisation d'un modulateur sigma-delta d'ordre élevé à boucle unique

(43) Date of publication of application: 06.10.1999
(73) Proprietor: STMicroelectronics S.r.l., 20041 Agrate Brianza (Milano) (IT)
(72) Inventor: Bianchessi, Marco, 20066 Melzo (IT); Dalle Feste, Sandro, 28100 Novara (IT); Serina, Nadia, 25030 Castelcovati (IT); Angelici, Marco, 21020 Galliate Lombardo (IT); Osnato, Fabio, 20131 Milano (IT)
(74) Representative: Pellegri, Alberto

(56) References cited:
- WO-A-95/34955
- US-A- 4 987 416
- S NORSOWORTHY: 'Delta-sigma data converters: theory, design, and simulation' IEEE PRESS 1997, NEW-YORK, pages 143 - 144

## Description

### BACKGROUND OF THE INVENTION

Sigma delta modulators used in digital/analog and analog/digital converters, and particularly those of high order (≥2) are likely to have instability problems which must to be accurately checked.

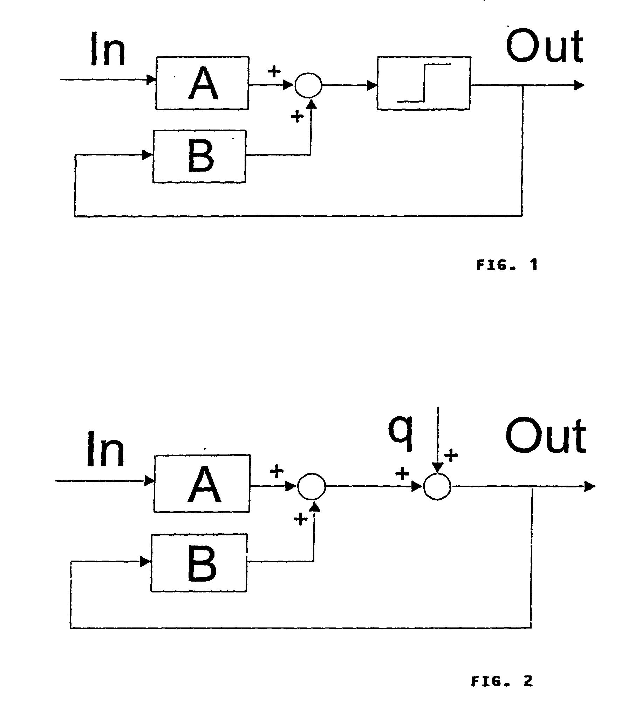

A sigma-delta modulator may be represented as in Fig. 1.

The function of such a structure is that of reducing the "precision" of the digital input signal (IN), while keeping unaltered its quality. This is done by using a quantizer that eliminates some of the precision bits while a feedback block keeps the noise introduced by the quantizer in a frequency band different from the frequency band of the signal.

In an extreme case, the quantizer reduces the signal to one bit, so that the function may be implemented with a simple comparator.

A thorough analysis of the performance of the system depicted in Fig. 1 cannot be done by using the normal techniques that are used for analyzing linear networks because of the presence of a nonlinear block (the quantizer).

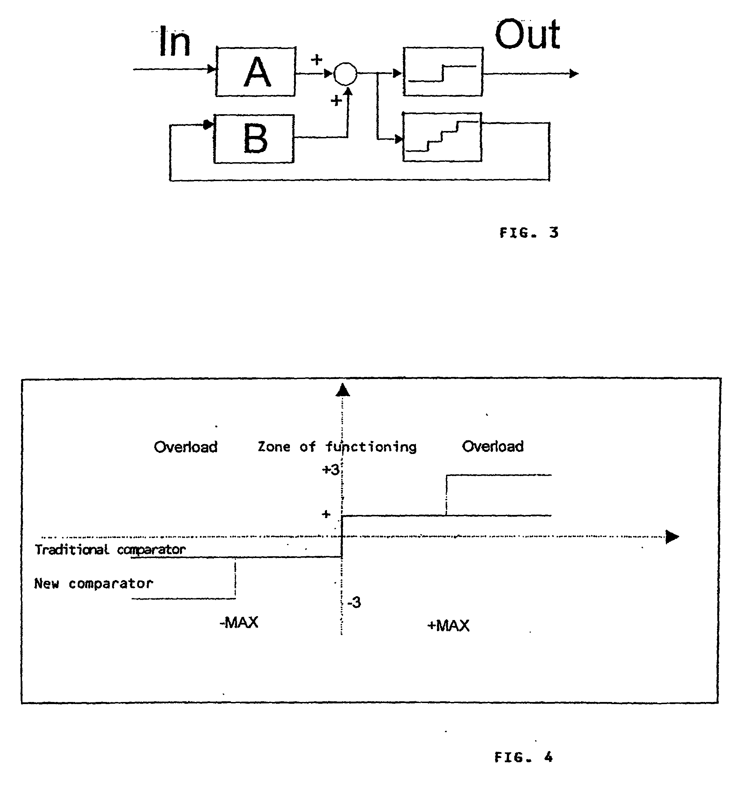

However, it is possible to operate a linearization of the modulator in order to obtain a model capable of providing qualitative indications of the system's behavior. To do this, the quantizer is modeled as an external source of noise "q" (hypothesis of additive white noise), thus eliminating any nonlinear block from the system, and thereafter the output signal contribution of the input signal and of the added noise. The equivalent scheme becomes that shown in Fig. 2.

By solving the block diagram of Fig. 2, the following expression is obtained:$\text{Out(z) = In(Z)*[A(Z)/1-B(Z)]+q(Z)*[1/1-B(Z)].}$

It may be deduced that the output is composed of the input signal filtered by the function [A(Z)/1-B(Z)] and of the noise filtered by the function [1/1-B(Z)]. By appropriately defining the two functions A(Z) and B(Z) it is possible to obtain the desired functions for both the input signal and for the noise.

In order to keep the signal and the noise separated in frequency, A(Z) and B(Z) are chosen so that the system behaves as a low-pass filter for the signal and as a highpass filter for the quantization noise.

The performance of sigma-delta modulators increase with the order of the A(Z) and B(Z) functions, but arises the problem of ensuring closed loop stability for orders ≥2.

The problem is more subtle than it may appear because the quantizer is a nonlinear block, as explained in "Delta-sigma data converters; theory, design, and simulation" IEEE Press 1997, S. Norsoworthy et al., pages 143-144, chapter "4.2.1 The Linear Model", ISBN D-7803-1045-4.

In particular it is even possible that the comparator be providing for a certain gain. Such a gain strongly depends on the input signal amplitude: if the signal amplitude increases, this fictitious gain of the comparator decreases.

The stability of a feedback system is strongly conditioned by the open loop gain: for a certain interval of gain values the stability is secured, while outside this interval the system becomes unstable.

Usually, in the case of Sigma-Delta modulators, the system is such that excessively low gains provoke a state of instability. Thence, an irreversible phenomena takes place: if by any reason the signal upstream of the comparator grows excessively, the gain of the comparator decreases, this in turn reduces the loop gain and the system egresses the stability region. In such a state of instability the internal signals increase and the system is prevented from regaining a correct functioning.

This type of phenomenon is very common in Sigma-Delta modulators and to obviate it there are different techniques more or less complex.

The problem of instability arises rarely and only under particular conditions: typically at switch-on and in the case of low frequency signals of large amplitude. However, it is very important to bring back the system to a correct functioning, otherwise it will remain unstable even after the triggering conditions have ended and the sigma-delta modulator would stop functioning at the first critical signal.

### DISCUSSION OF THE PRIOR ART

Traditional approaches to cure these problems are based on the principle of recognizing the state of instability, and accordingly intervene on the internal states to bring the system back to an operating point within the stability zone.

These methods differ among each other on how the state of instability is detected and in the way the system is brought back to a correct functioning.

These known solutions go from the simpler system that intervenes only when a register overflows by zeroing all the internal states, to more complex systems wherein critical situations are recognized before they degenerate into a real instability and therefore an intervention is limited to just an appropriate point, without major repercussions on the system as a whole.

The document WO 95/34955 discloses a novel oversampled high-order sigma-delta modulator comprising cascaded integrators wherein instability phenomena are recovered by temporarily changing the feedback conditions upon detecting an unstable mode.

### SUMMARY OF THE INVENTION

Differently from known systems, the novel system that has been found contemplates an internal modification of the system rather than the addition of dedicated external controlling means. By this modification, the Sigma-delta modulator becomes unconditionally stable, in practice it never exits the stability zone irrespectively of the amplitude of the input signal. In order to illustrate this invention, it is important to bear in mind the purpose of the comparator. The comparator is required to provide as output a one bit signal so as to be able to convert it into an analog signal

by the use of a simple electronic switch. Therefore, it is not rational to have an output signal of a larger a number of bits because this would require a more complex analog stage in cascade thereto.

By contrast, as long as the feedback is concerned, a multibit signal may be perfectly fit for the conventional architecture without creating substantial complications.

Fundamentally, the invention is based upon the use of two distinct comparators: a conventional one-bit comparator destined to generate the output signal, and a second or auxiliary multilevel comparator dedicated to the generation of a feedback signal.

In this way, the signal path through the sigma-delta modulator splits upstream of the quantizer, allowing for a diversification of the feedback signal from the output signal.

### BRIEF DESCRIPTION OF THE PRAWTNGS

**Figure 1** represents the basic functional scheme of a sigma-delta modulator;
**Figure 2** is an equivalent scheme of a sigma-delta modulator;
**Figure 3** is a functional block diagram of a sigma-delta modulator made according to the present invention;
**Figure 4** is a diagram that illustrates the functioning of a sigma-delta modulator of the invention in conditions of intrinsic stability.

### DESCRIPTION OF AN EMBODIMENT

A basic functioning scheme of the sigma-delta modulator of the invention of Fig. 3, employing a second, multilevel comparator that produces a logic feedback signal, is depicted in Fig. 4 for an immediate comparison with the scheme of Fig. I of a modulator of the prior art.

While in a sigma-delta modulator of the prior art of Fig. 1, the single level comparator Comp outputs the value +1 when the input is positive regardless of its absolute value, and the value -1 when the input is negative sign, in the modulator of the invention of Fig. 3, the second comparator Comp2 follows exactly the behavior of the first comparator for input signal values comprised in a certain interval, whereas for values outside the interval, the output level is, according to the considered embodiment, at +/-3, as shown in the Figure.

This has no consequence as long as the input signal remains within the fixed limits of amplitude and thus in this "normal" operation zone, the sigma-delta modulator of the invention behaves exactly as a normal modulator of the prior art.

By contrast, when the input signal to the comparator exceeds a certain threshold, which occurs only in conditions approaching those of instability, the output goes to a higher level, thus increasing the loop gain and the feedback signal becomes multibits, in the example a 2bits signal.

In the embodiment considered, the logic levels +3 and -3 are so chosen for making the comparator as linear as possible. Simulation test have demonstrated that these levels minimize the noise in a condition of overload.

This simple modification guarantees an unconditioned stability as may be easily verified by testing under the same conditions the prior art system of Fig. 1 and the system of the invention of Fig. 3.

It may be noted that in all cases where the input signal generates instability in the prior art system, the system of the invention responds without manifesting any instability. The only negative consequence is a limited degradation of the output signal-to-noise ratio.

This occurs because in a condition of overload the output signal and the feedback signal are different from each other and therefore the noise is no longer correctly compensated. However, the degradation of the signal-to-noise is substantially negligible if compared to the one that occurs when using traditional stabilizing solutions.

An advantage procured by the sigma-delta modulator of the invention is a better behavior than conventional circuits.

This improved performance is obtained with a very simple structure that most effectively substitutes in its function the far more complex external controller that is commonly employed in the known systems, remarkably decreasing costs.

A further advantage of the new self-stabilizing method of the invention, is the possibility to deliberately design the sigma-delta modulator to enter an overload zone when the input signal is dynamically at its a maximum value. In this case, at the price of a minor degradation of the signal-to-noise ratio it is made possible to exploit fully the available dynamic of the input signal on the analog voltages. Such a compromise becomes particularly advantageous in converting power, where it is important to maximize the power that may be delivered for the same supply voltage and where the degradation caused by the digital part is amply masked by the distortion which is unavoidably introduced by the analog stage of the converter.

## Claims

1. A sigma-delta modulator of second or higher order, comprising two or more integrating stages (A), a comparator (Comp) in cascade to said integration stages, generating a signal of logic level +1 when the input signal is positive or of logic value -1 when the input signal is negative, regardless of its absolute value, a feedback line comprising at least a low-pass filter (B) and adder means adding a feedback signal, filtered by said low-pass filter (B) to the signal output by the last of said integrating stages (A), **characterized in that** it further comprises
a second comparator (Comp2) having an input connected in common to the input of the first comparator (Comp) and outputting a logic signal of positive value when the input signal is positive and of negative value when the input signal is negative, but of increasing logic level when the input signal exceeds one or more predefined thresholds of increasing value and said output logic signal being fed to the input of said low-pass filter (B).

## Patentansprüche

1. Sigma-Delta-Modulator zweiter oder höherer Ordnung, aufweisend zwei oder mehr Integrationsstufen (A), einen Komparator (Comp) in Kaskade mit den Integrationsstufen, erzeugend ein Signal mit dem logischen Pegel +1, wenn das Eingangssignal positiv ist, oder mit dem logischen Pegel -1, wenn das Eingangssignal negativ ist, ungeachtet seines absoluten Wertes, eine Rückführungsleitung mit zumindest einem Tiefpassfilter (B) und Additionsmitteln zum Addieren eines Rückführungssignals, das durch das Tiefpassfilter (B) gefiltert wurde, zu dem von der letzten der Integrationsstufen (A) ausgegebenen Signal, **dadurch gekennzeichnet, daß** er weiterhin aufweist: einen zweiten Komparator (Comp2) mit einem Eingang, der gemeinsam mit dem Eingang des ersten Komparators (Comp) verbunden ist, der ein logisches Signal mit positivem Wert ausgibt, wenn das Eingangssignal positiv ist, und mit negativem Wert, wenn das Eingangssignal negativ ist, aber mit zunehmendem logischen Pegel, wenn das Eingangssignal einen oder mehrere vorbestimmte Schwellenwerte von zunehmendem Wert überschreitet, und das ausgegebene logische Signal zu dem Eingang des Tiefpassfilters (B) geführt wird.

## Revendications

1. Modulateur sigma-delta du second ordre ou d'un ordre plus élevé, comprenant deux étages d'intégration ou plus (A), un comparateur (Comp) en cascade avec les étages d'intégration, produisant un signal de niveau logique +1 quand le signal d'entrée est positif ou de valeur logique -1 quand le signal d'entrée est négatif, quelle que soit sa valeur absolue, une ligne de réaction comprenant un filtre passe-bas (B) et un moyen additionneur ajoutant un signal de réaction, filtré par le filtre passe-bas (B) vers la sortie du signal par le dernier des étages d'intégration (A), **caractérisé en ce qu'**il comprend en outre :
un second comparateur (Comp2) ayant une entrée connectée en commun avec l'entrée du premier comparateur (Comp) et fournissant un signal logique de valeur positive quand le signal d'entrée est positif et de valeur négative quand le signal d'entrée est négatif, mais de niveau logique croissant quand le signal d'entrée dépasse un ou plusieurs seuils prédéfinis de valeurs croissantes, et le signal logique de sortie étant fourni à l'entrée du filtre passe-bas B.
